(19) Europäisches Patentamt
European Patent Office
Office européen des brevets

(11) EP 2 461 661 A2

(12) **EUROPEAN PATENT APPLICATION**

(43) Date of publication:
06.06.2012 Bulletin 2012/23

(51) Int Cl.:
H05K 7/20 (2006.01)

(21) Application number: 11191532.8

(22) Date of filing: 01.12.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 01.12.2010 JP 2010268211

(71) Applicant: Hitachi Ltd.
Tokyo 100-8280 (JP)

(72) Inventors:
• Tsubaki, Shigeyasu
Tokyo, 100-8220 (JP)
• Idei, Akio
Tokyo, 100-8220 (JP)

(74) Representative: MERH-IP
Matias Erny Reichl Hoffmann
Paul-Heyse-Straße 29
80336 München (DE)

(54) **Electronic apparatus rack and data center**

(57) An electronic apparatus rack (101) which can prevent the degradation of cooling performance due to local heat concentration on the exhaust side of the server (301). The electronic apparatus rack (101) having electronic apparatuses (301) mounted thereon, consists of a radiator (200) incorporated in the rear door (102) of the electronic apparatus rack (101); plural fans (103) installed on the exhaust side of the radiator (200); and plural heat pipes (602) installed on the intake side of the radiator (200).

FIG.1

EP 2 461 661 A2

**Description**

BACKGROUND OF THE INVENTION

This invention relates to an electronic apparatus rack, and more particularly to an improvement in cooling performance in an electronic apparatus rack incorporating therein one or more servers wherein the temperature distribution of the exhaust air from one or more servers is uneven to a considerable extent.

Heat generation in such a semiconductor device as a central processing unit (CPU) incorporated in an electronic apparatus like a personal computer or a server, tends to increase due to the ongoing reduction in size of the semiconductor device and the ongoing largescale integration. Accordingly, there is an increasing demand for enhancing the capacity of an air conditioner used for a rack on which servers are mounted or a data center which administers racks as a whole.

In order to meet such a requirement, a system has recently been proposed in, for example, JP-A-2010-041007 (corresponding to US 2010/0033931) (patent document No. 1), in which a heat exchanger (radiator) is provided in the door attached to the exhaust side of the rack, and heat of exhaust air in the room for the system is dissipated into the ambient air outside the room by causing refrigerant to flow through the radiator.

This system having the radiator situated immediately on the downstream side of the server rack, has an advantage that heat exchange takes place before exhaust heat diffuses in the room so that effective cooling can be attained.

SUMMARY OF THE INVENTION

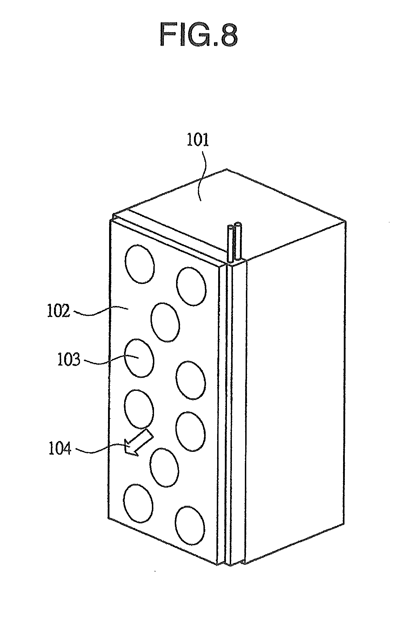

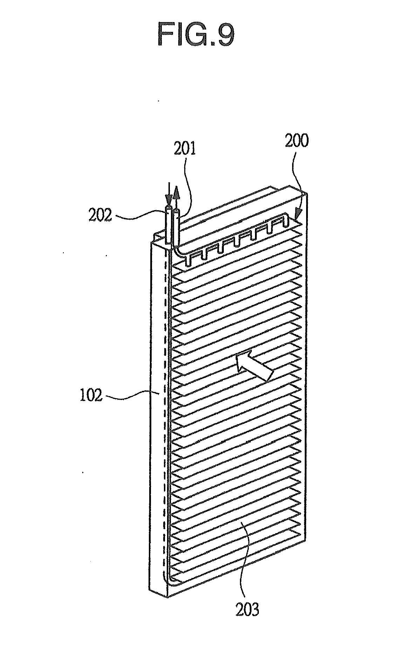

Figs. 8 and 9 show an example of such a conventional cooling system as mentioned above. Fig. 8 schematically shows in perspective view a conventional cooling system, and Fig. 9 schematically shows in perspective view the rear door structure of the conventional cooling system shown in Fig. 8.

In Fig. 8 are shown in perspective an electronic apparatus rack 101 incorporating a server and the rear door 102 provided with a radiator and attached to the electronic apparatus rack 101. The rear door 102 is provided with plural fans 103 which guide winds in the direction indicated by the arrow 104 and serve to compensate fluid resistance of the radiator from the viewpoint of the fans inside electronic equipment.

In Fig. 9 is shown in perspective the rear door 102 as viewed from on the windward side. The rear door 102 is provided with a refrigerant pipe 201 for carrying refrigerant which has absorbed heat and a refrigerant pipe 202 for carrying refrigerant which has not yet absorbed heat. The pipes branch out within the door and a number of fins 203 are attached to the pipes for heat exchange.

Through this heat exchange system described above, absorbed heat is transferred through the refrigerant pipe 201 to the coupled outdoor heat exchanger, which in turn dissipates the transferred heat into the ambient air.

However, this system has two problems discussed below.

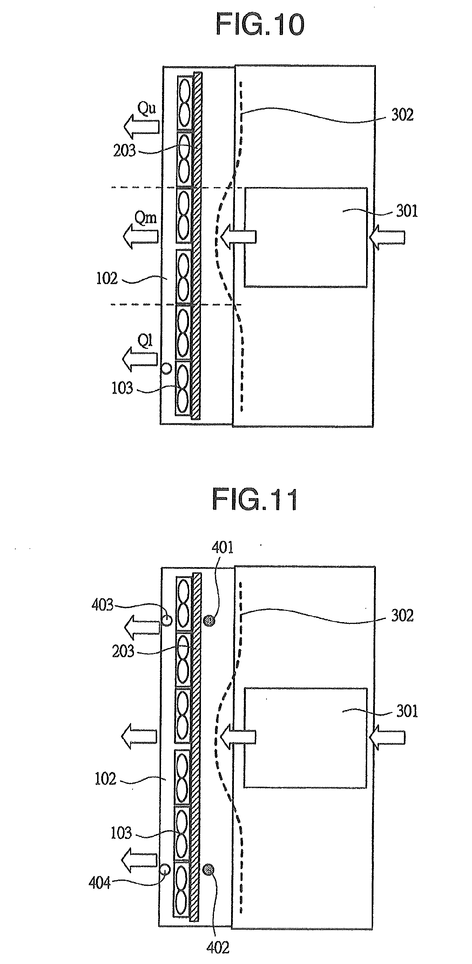

The two problems will now be discussed with reference to Figs. 10 and 11 of the attached drawings. Fig. 10 illustrates the temperature distribution of exhaust air from the server installed in a conventional electronic apparatus rack having its rear door, in vertical cross section laterally viewed. Fig. 11 shows the locations of temperature sensors in the conventional electronic apparatus rack shown in Fig. 10, in vertical cross section laterally viewed.

One of the problems is that since the radiator is situated very near to the exhaust side of the server, high-temperature exhaust air directly hits the radiator so that local degradation of heat exchange occurs.

Fig. 10 shows in lateral, cross-sectional view the rack and the server mounted thereon, simulating the situation of the first problem.

The server 301 mounted on the electronic apparatus rack 101 is consuming electric power nearly equal to the maximum tolerable heat amount $Q_{max}$ of the rear door according to a program for handling a heavy load. Consequently, the temperature distribution curve for the exhaust air represented by a dashed curve 302 bulges sideways (in the direction of wind), indicating that the temperature of exhaust air is unusually high on and near the exhaust side of the server.

Let the space occupied by the rack be divided into upper area, middle area and lower area, and let them be named $Q_u$, $Q_m$, and $Q_1$, respectively, as shown in Fig. 10. The above mentioned bulge of the temperature distribution curve 302 means that heat concentration occurs in the middle area $Q_m$. Accordingly, the heat concentration generates large difference in temperature so that heat exchange takes place outstandingly at the particular point of high temperature (i.e. in the middle area $Q_m$).

The amount Q of heat transfer or exchanged heat is generally given by the following expression.

$$Q = (T2 - T1) \times h \times A,$$

where T1 denotes the temperature of fins, T2 the temperature on the intake side of the door (on the immediately windward side of the radiator), h the coefficient of heat transfer, and A the total surface area of all the fins.

The total surface area A is determined depending on the physical dimensions of the radiator and therefore is a constant. The heat transfer coefficient h is determined depending on the rate of air flow or the sort of fluid flowing among the fins. The temperature T2, which is a state quantity, is determined uniquely depending on the amount of heat generated by the server and the amount of wind (i.e. air flow). Heat concentration, which should be avoided if possible, can be rephrased as an increase in the value of T2.

On the other hand, the fin temperature T1 can be kept constant if the temperature of refrigerant is kept constant and if a sufficient amount of refrigerant is available. But it does not mean that the amount of refrigerant increases in accordance with the generated heat concentration. It does mean that an increase in the amount of refrigerant may generally cause an increase in flow resistance of refrigerant in proportion to the square law of amount of refrigerant.

Consequently, if heat concentration occurs in an area, even the maximum cooling capacity available in the area cannot sufficiently dissipate heat concentrating in the area. As a result, air of abnormally higher temperature is exhausted from the area which is otherwise cooled to a predetermined temperature, and therefore cooling performance becomes lower though the tolerable amount of heat generation is strictly observed.

Further, the second problem mentioned above is that the uneven temperature distribution described above will make it difficult to measure cooling performance with high precision. As shown in Fig. 11, according to the prior art, temperature sensors are installed on the intake and exhaust sides of the radiator, and the cooling performance (i.e. amount of heat exchange) of the radiator is measured depending on the average of the temperature differences, each temperature difference being between the temperature detected by the temperature sensor installed on the exhaust side of the radiator and the temperature detected by the corresponding temperature sensor installed on the intake side of the radiator. Thus, the result of measurement can be revealed to customers.

However, if such a local heat concentration as described above occurs, the detected values of the intake-side temperature sensors do not properly contribute to the average temperature of the intake air (in fact, as in the case shown in Fig. 11, the temperatures detected by the intake-side temperature sensors 401, 402 become lower than the average temperature). One of the countermeasures to eliminate this sort of measurement failure is to install as many temperature sensors as possible to grasp an accurate temperature distribution.

This measure, however, is problematic in terms of cost and maintenance and also unrealistic.

The object of this invention, which has been made to solve such problems incidental to the prior art counterparts as described above, is to provide an electronic apparatus rack which can prevent the degradation of cooling performance due to local heat concentration on the exhaust side of the server mounted on the rack.

The aforementioned and further objects and features of this invention will become apparent when one reads the following description of this specification in conjunction with the attached drawings.

Typical examples of this invention disclosed herein will be enumerated as follows.

A first example is an electronic apparatus rack having a rear door, the rear door comprising a radiator incorporated in the rear door; plural fans installed on the exhaust side of the radiator; and plural heat pipes installed on the intake side of the radiator.

A second example is an electronic apparatus rack having a rear door and a front door, comprising plural fans mounted on the rear door side of the electronic apparatus rack; and plural heat pipes mounted on the front door side of the electronic apparatus rack.

A typical advantage obtained by the typical examples of this invention described above will be explained as follows.

The typical advantage is that the temperature distribution of the radiator intake air can be uniform. Accordingly, cooling operation can be prevented from exceeding its limiting threshold due to uneven temperature distribution so that a desired, stable cooling operation can be secured.

Other objects, features and advantages of the invention will become apparent from the following description of the embodiments of the invention taken in conjunction with the accompanying drawings.

BRIEF DESCRIPTION OF THE DRAWINGS

Fig. 1 shows in perspective, exploded view the structure of an electronic apparatus rack according to a first embodiment of this invention.

Fig. 2 illustrates, in vertical cross-sectional view, the temperature distribution of the ventilation air downstream of the server installed on the electronic apparatus rack according to the first embodiment of this invention.

Fig. 3 illustrates, in vertical cross-sectional view, the positions of temperature sensors placed in the electronic apparatus rack with the server mounted thereon, according to the first embodiment of this invention.

Fig. 4 shows in detail the structure of only the rear door of the electronic apparatus rack according to a second embodiment of this invention.

Fig. 5 graphically shows the relationship between the air flow rate and the ratio of the area occupied by all the flat-type heat pipes 801 to the entire cross sectional area of the air flow path, regarding the electronic apparatus rack according to the second embodiment of this invention.

Fig. 6 shows in perspective, exploded view the structure of only the front door of the electronic apparatus rack as a third embodiment of this invention.

Fig. 7 illustrates how heat exchange takes place in a data center according to a fourth embodiment of this invention, wherein plural electronic apparatus racks are provided.

Fig. 8 schematically shows in perspective view a conventional cooling system.

Fig. 9 schematically shows in perspective view the rear door structure of the conventional cooling system shown in Fig. 8.

Fig. 10 illustrates the temperature distribution of exhaust air from the server installed in a conventional electronic apparatus rack having its rear door, in vertical cross section laterally viewed.

Fig. 11 shows the locations of temperature sensors in the conventional electronic apparatus rack shown in Fig. 10, in vertical cross section laterally viewed.

DESCRIPTION OF THE EMBODIMENTS

Modes of practice according to this invention will be described in detail below in reference to the attached drawings. Throughout all the sheets of drawings, equivalent parts or members are labeled with the same reference numerals, and the description of the parts or members once described will not be repeated.

[First embodiment]

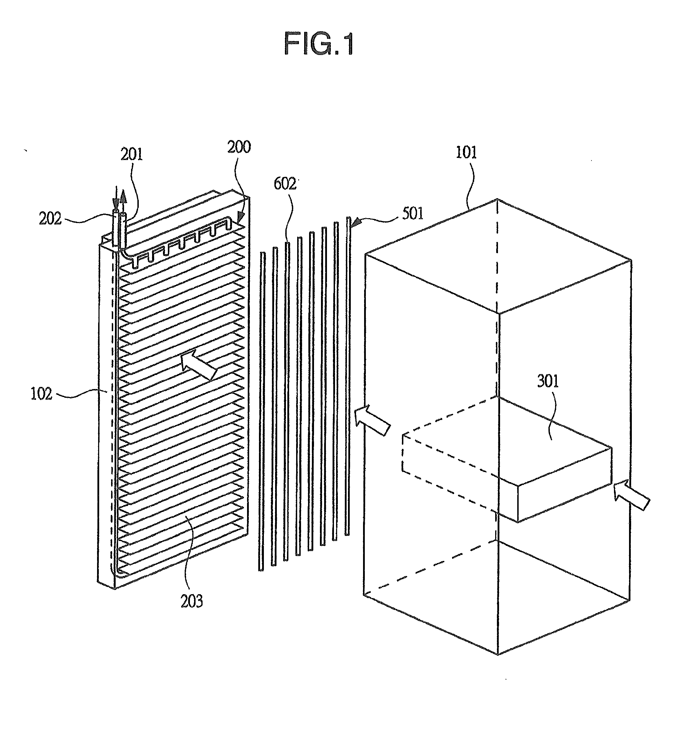

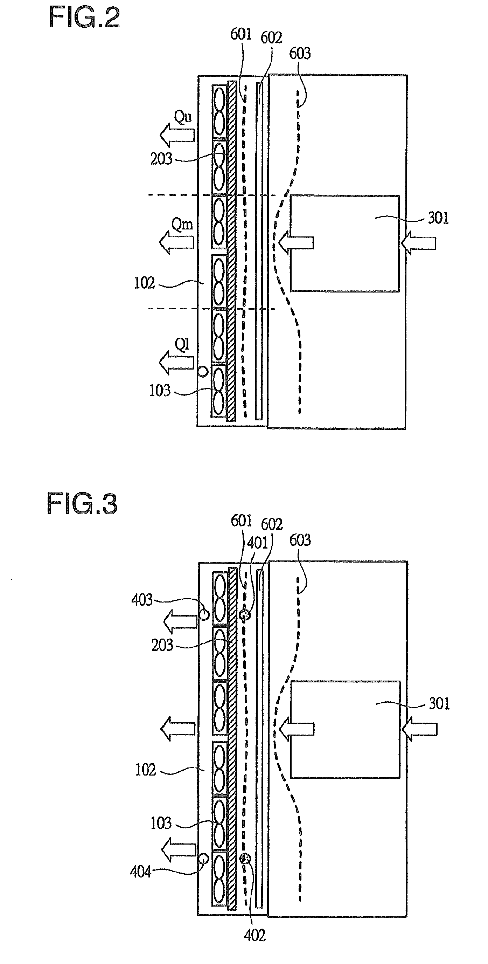

With reference to Figs. 1 through 3, description is made of the structure of an electronic apparatus rack according to a first embodiment of this invention. Fig. 1 shows in perspective, exploded view the structure of an electronic apparatus rack according to a first embodiment of this invention, in which a server is installed and to which a door incorporating a radiator is attached on the exhaust side of the rack. Fig. 2 illustrates, in vertical cross-sectional view, the temperature distribution of the exhaust air immediately downstream of the server installed on the electronic apparatus rack according to the first embodiment of this invention. Fig. 3 illustrates, in vertical cross-sectional view, the positions of temperature sensors placed in the electronic apparatus rack with the server mounted thereon, according to the first embodiment of this invention.

As shown in Fig. 1, an electronic apparatus rack 101 is provided with a rear door 102 attached on the exhaust side of the rack 101, and a radiator 200 is incorporated in the rear door 102. The radiator 200 includes refrigerant pipes 201, 202 which branch out within the rear door 102 and have a number of fins 203 coupled thereto for heat exchange. Through this heat exchange mechanism, absorbed heat is transferred out of the room by way of the refrigerant pipes 201, 202.

On the windward side of the fins 203 is mounted a unit 501 consisting of plural heat pipes 602, which can dissipate heat transmitted to the middle portions thereof due to the exhaust air from a server 302, up and down vertically along the heat pipes 602 under capillary phenomenon.

Also, as shown in Fig. 2, plural fans 103 are incorporated within the rear door 102, and the fans 103 serve to compensate for the pressure loss in the radiator 200 mounded within the rear door 102.

Now, description will be made of temperature distribution in exhaust air from the server 301 when it is mounted on the rack 101.

In Fig. 2, when only one server 301 is mounted on the electronic apparatus rack 101 and when the server 301 is operating under a heavy load, the temperature distribution immediately on the exhaust side of the server 301 takes a laterally bulging characteristic 603 represented by a dashed curve.

This temperature distribution 603 indicates that there is a remarkable heat concentration. The air of concentrated heat passes through the assembly of the heat pipes 602 so that it is subjected to heat transfer due to condensation and evaporation caused between the low and high temperature portions of the heat pipes 602. Accordingly, the temperature distribution of the air that has passed through the assembly of the heat pipes 602 becomes flattened as indicated by a dotted straight line 601.

The locations of temperature sensors will be discussed below. Fig. 3 shows the locations of temperature sensors mounted on the rear door 102: intake air temperature sensors 401, 402 situated on the intake side of the radiator; and exhaust air temperature sensors 403, 404 situated on the exhaust side of the radiator. Heat exchange amount is calculated depending on the difference between the average of the air temperatures detected by the exhaust and intake air temperature sensors 403, 401 and the average of the air temperatures detected by the exhaust and intake air temperature sensors 404, 402.

In this case, too, as shown in Fig. 3, the temperature of the exhaust air immediately after the server 301 is relatively high as indicated by the laterally bulging temperature characteristic curve 603. According to this embodiment of this invention, however, the air temperature distribution in the space where the intake and exhaust air temperature sensors 401, 402, 403 and 404 are located, is almost uniform as indicated by the flat temperature characteristic curve 601. That is, the unevenness in the temperature distribution of the exhaust air is corrected and a suitable temperature value is attained that is approximately equal to the value calculated on the basis of the above mentioned averages of the temperatures detected by the intake and exhaust air temperature sensors 401, 402, 403 and 404.

As described above, according to this embodiment, the effect of correcting unevenness in temperature distribution can be obtained, and therefore there is no need for providing too many temperature sensors, that is, the number of temperature sensors that may otherwise be installed can be reduced. Note that the embodiment of this invention may not be limited to the structure shown in Fig. 3, but may include a number of variations.

[Second embodiment]

A second embodiment of this invention is different from the first embodiment described above in that a flat-type heat pipe assembly is used.

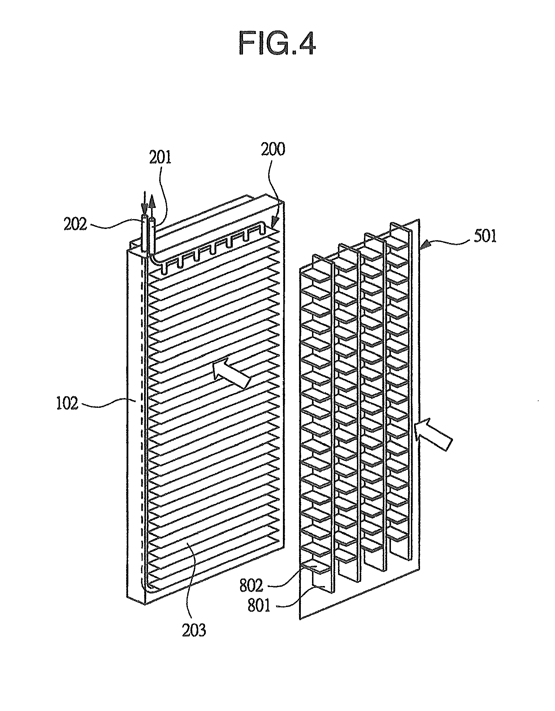

The structure of an electronic apparatus rack according to the second embodiment of this invention will now be described with reference to Fig. 4. Fig. 4 shows in detail the structure of only the rear door of the electronic apparatus rack according to the second embodiment of this invention.

As shown in Fig. 4, each heat pipe 801 in the unit 501 is not like a round rod as generally known, but is a flat-type heat pipe 801, i.e. a metal strip with fins 802 of copper or aluminum joined thereto with solder, etc.

This structure can more effectively dissipate concentrated heat.

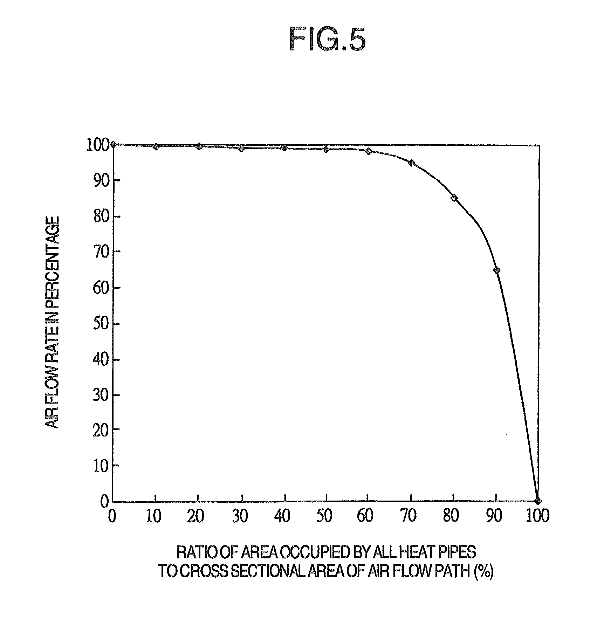

Now, the relationship between the air flow rate and the ratio of the whole area occupied by all the heat pipes 801 to the entire cross sectional area of the air flow path, regarding the electronic apparatus rack according to the second embodiment of this invention, will be described with reference to Fig. 5. Fig. 5 graphically shows the relationship between the air flow rate and the ratio of the whole area occupied by all the flat-type heat pipes 801 to the entire cross sectional area of the air flow path, regarding the electronic apparatus rack according to the second embodiment of this invention.

As interpreted from the graph shown in Fig. 5, an increase in the number of flat-type heat pipes 801 results in an improve in the effect of mitigating heat concentration, but also causes an increase in pressure loss of exhaust air passing through the rear door 102 and therefore a decrease in air flow rate. Although the extent of the decrease in air flow rate varies depending on the dimensions of the radiator and the pressure loss characteristic, the ratio of the area occupied by all the flat-type heat pipes 801 to the cross sectional area of the air flow path is calculated here under the condition that the heat exchange capacity of the rear door 102 is about 10 kW.

Since the air flow rate falls steeply as the area proportion of the flat-type heat pipes 801 becomes greater than 70%, the ratio must preferably be set less than 70%.

[Third embodiment]

A third embodiment is different from the second embodiment described above in that the unit 501 including heat pipes with fins is provided in the front door of the electronic apparatus rack, not in the rear door as in the second embodiment.

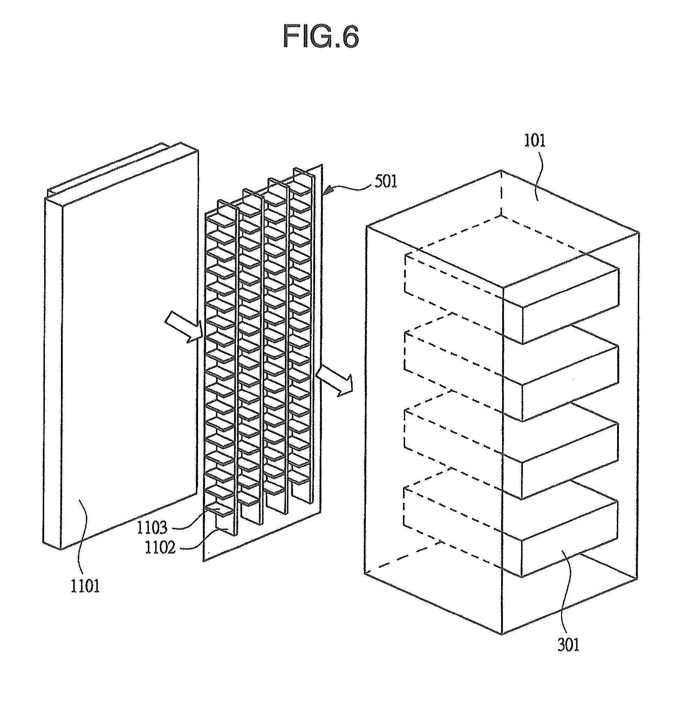

The structure of an electronic apparatus rack as the third embodiment of this invention will be described with reference to Fig. 6. Fig. 6 shows in perspective, exploded view the structure of the front door of the electronic apparatus rack as the third embodiment of this invention.

As shown in Fig. 6, the electronic apparatus rack 101 incorporates therein plural servers 301, and the front door 1101 is provided with a unit 501 consisting of flat-type heat pipes 1102 with fins 1103 attached thereto.

Note that the rear door is provided with plural fans.

Thus, according to the third embodiment of this invention, the flat-type heat pipes 1102 are situated in the front door 1101 so that the flat-type heat pipes 1102 can make uniform the temperature distribution of the air entering the rack 101 from on the side of the front door 1101. Accordingly, it is possible to cool the servers 301 in the electronic apparatus rack 101 with a high efficiency.

This cooling mechanism can effectively be used in a data center using an ordinary air conditioning system, where heat concentration occurs due to the design and layout of the electronic apparatus rack 101 and the associated servers, resulting in an uneven temperature distribution of the air entering the electronic apparatus rack 101.

[Fourth embodiment]

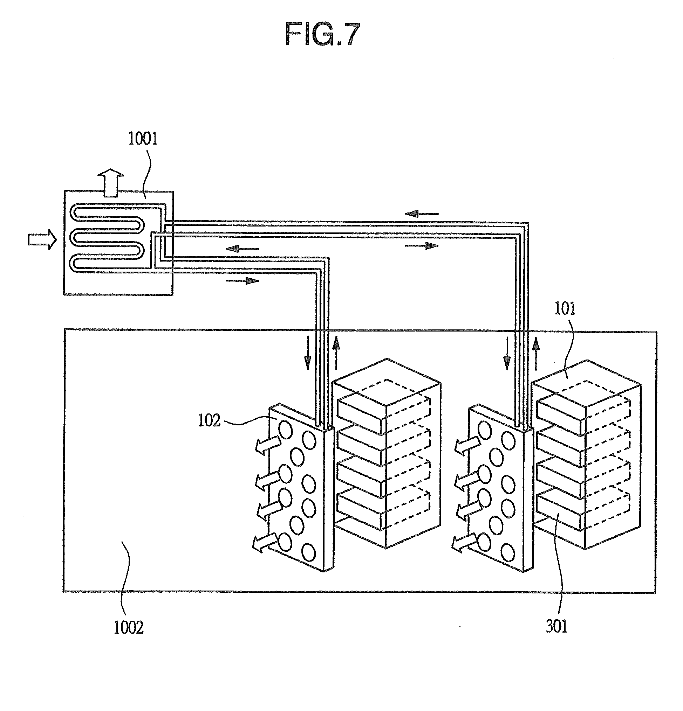

Fig. 7 illustrates how heat exchange takes place in a data center according to a fourth embodiment of this invention, wherein plural electronic apparatus racks are provided. Fig. 7 schematically shows the structure of the data center provided with the plural electronic apparatus racks, whereby heat exchange is performed between the air in the data center and the ambient air.

As shown in Fig. 7, the data center 1002 incorporates therein plural electronic apparatus racks 101, and the rear doors 102 of the plural electronic apparatus racks 101 are provided with such units 501 as described with the foregoing first and second modes of practice.

In the example shown in Fig. 7, the data center 1002 includes two electronic apparatus racks 101; each electronic apparatus rack 101 is provided with the rear door 102 incorporating a radiator; the rear doors 102 incorporate therein refrigerant pipes; heat absorbed by the radiators installed in the rear doors 102 is transferred to an outdoor heat exchanger 1001 by means of the refrigerant pipes; and the transferred heat is dissipated into the ambient air through heat exchange in the outdoor heat exchanger 1001.

Note that in the fourth embodiment of this invention the refrigerant is naturally circulated since the outdoor heat exchanger 1001 is situated higher by a predetermined distance than the rear doors 102 and the cooling circuit is filled with a proper amount of refrigerant for continuous refrigerant flow.

Consequently, according to the fourth embodiment of this invention, heat exchange can be performed without a pressure pump.

As described heretofore, this invention was explained by way of embodiment, but it is needless to say that this invention is not limited only to those modes of practice described above, but can be embodied in various ways other than disclosed in this specification so long as what may come out is within the spirit and scope of this invention.

This invention relates to an electronic apparatus rack and can be applied widely to the field of cooling server racks wherein the temperature distribution of the exhaust air from plural servers is uneven to a considerable extent.

It should be further understood by those skilled in the art that although the foregoing description has been made on embodiments of the invention, the invention is not limited thereto and various changes and modifications may be made without departing from the spirit of the invention and the scope of the appended claims.

## Claims

1. An electronic apparatus rack (101) having electronic apparatuses (301) mounted thereon, comprising:

   a radiator (200) incorporated in a rear door (102) of the electronic apparatus rack (101);
   plural fans (103) installed on an exhaust side of the radiator (200); and
   plural heat pipes (602) installed on an intake side of the radiator (200).

2. An electronic apparatus rack (101) as claimed in Claim 1, wherein a heat exchanger (1001) is provided which is coupled to the radiator (200) via refrigerant pipes (201, 202); the heat exchanger (1001) is situated higher in position than the rear doors (102); and the radiator (200) is loaded with such an amount of refrigerant as can make possible the natural circulation of refrigerant between the radiator (200) and the heat exchanger (1001).

3. An electronic apparatus rack (101) as claimed in Claim 1, wherein an effective area that the plural heat pipes (602) occupy is not less than 70% of an area that the radiator (200) occupies.

4. An electronic apparatus rack (101) as claimed in Claim 1, further comprising:

   intake side temperature sensors (401, 402) installed between the radiator (200) and the plural heat pipes (602);
   exhaust side temperature sensors (403, 404) installed on the exhaust side of the radiator (200), wherein the rotational speeds of the plural fans (103) are determined depending on the values of temperatures detected by the intake side temperature sensors (401, 402) and the exhaust side temperature sensors (403, 404).

5. An electronic apparatus rack (101) having electronic apparatuses (301) mounted thereon, comprising:

   plural fans (103) installed on a rear door (102) side of the electronic apparatus rack (101); and
   plural heat pipes (1102) installed on a front door (1101) side of the electronic apparatus rack (101).

6. A data center which is air-conditioned and in which such plural electronic apparatus racks (101) as recited in Claim 2 are mounted.

7. A data center which is air-conditioned and in which such plural electronic apparatus racks (101) as recited in Claim 5 are mounted.

# FIG.1

FIG.2

FIG.3

# FIG.4

FIG.5

RATIO OF AREA OCCUPIED BY ALL HEAT PIPES
TO CROSS SECTIONAL AREA OF AIR FLOW PATH (%)

# FIG.6

# FIG.7

# FIG.8

# FIG.9

# FIG.10

# FIG.11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010041007 A
- US 20100033931 A